Europäisches Patentamt

European Patent Office

Office européen des brevets

(11) Publication number: **0 140 755 B1**

# EUROPEAN PATENT SPECIFICATION

(45) Date of publication of patent specification: 25.09.91　(51) Int. Cl.⁵: **H01L 21/306**

(21) Application number: 84401911.7

(22) Date of filing: 26.09.84

The file contains technical information submitted after the application was filed and not included in this specification

(54) **A plasma processor for IC fabrication.**

(30) Priority: 30.09.83 JP 182009/83

(43) Date of publication of application:
08.05.85 Bulletin 85/19

(45) Publication of the grant of the patent:
25.09.91 Bulletin 91/39

(84) Designated Contracting States:
**DE FR GB**

(56) References cited:
**DE-A- 3 318 566**
**US-A- 4 417 947**

**PATENT ABSTRACTS OF JAPAN, vol. 6, no.
111 (E-114)[989], 22nd June 1982; & JP-A-57
40 931**

(73) Proprietor: **FUJITSU LIMITED
1015, Kamikodanaka Nakahara-ku
Kawasaki-shi Kanagawa 211(JP)**

(72) Inventor: **Kisa, Toshimasa
958, Kamisakunobe Takatsu-ku
Kawasaki-shi Kanagawa 213(JP)**

(74) Representative: **Descourtieux, Philippe et al
CABINET BEAU de LOMENIE 55 rue
d'Amsterdam
F-75008 Paris(FR)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

### BACKGROUND OF THE INVENTION

The present invention relates to a wafer processing method and apparatus used for the fabrication of an integrated circuit (IC) semiconductor. More particularly, the present invention relates to a plasma processor having an improved high processing rate for use in an etching process in IC fabrication.

From the beginning of the IC industry, a wet etching method has been employed using sulphuric acids, hydrochloric acids or phosphoric acids, but,recently, the wet etching method has been replaced by a dry etching method, such as the plasma etching method. The plasma etching process has various advantages as compared with the wet etching method, such as capability for fine resolution and less under cutting, inherent cleanness, reduction of the number of fabrication steps such as elimination of wafer handling for rinsing and drying, and the like. The plasma etching method to which the present invention relates, makes it,in particular, possible to perform sequentially the etching and stripping operations on the same machine, allowing them to realize a fully automated fabrication for the IC.

Plasma is a highly ionized gas having nearly equal number of positive and negative charged particles and free radicals. The free radicals generated in the plasma, acting as a reactive species, chemically combine with materials to be etched, and form volatile compounds which are removed from the wafers by an evacuating device.

For forming fine patterns in an IC device, an etching process is carried out including, in particular, an "ashing" process which may be defined as a process for removing a photoresist mask. They are processes for etching off the protective layers of silicon, silicon dioxide, etc., and for removing a photoresist mask, which is usually an organic layer, respectively. Usually, for example, in the case of the ashing process, oxygen ($O_2$) is used as an etchant gas, and in the case of etching, a gas mixture including carbon tetrafluoride ($CF_4$) or carbontetrachloride ($CCl_4$), etc. is used with proper temperature and pressure.

Plasma processors can be classified into two types : in the first type, plasma is generated in a plasma generator and activated gases are brought onto the wafer and, in the second type, the wafers are placed in the plasma environment of a plasma generating area. The first method has some defects; the processing speed is very slow, and when it is used for etching processing, the surface of the wafer is not uniform. The second method has also some defects; the wafer exposed in a plasma environment is damaged by ion bombardment, radiation of ultraviolet rays, and soft X-rays and, moreover, the wafer is poisoned by impurities included in the gases, with the result that the quality of the wafer surface varies more widely.

A plasma processor of the first type is known from patent document JP-A-57 40931, in which the underside of the wafer is prevented from being etched by making it contact an inert gas contained within an underlying concavity, in order to perform etching on the top face of the wafer only.

There is also known from patent document DE-A-33 18566 a plasma etching apparatus comprising an etchant gas source, a plasma generating region, a microwave generator for energizing the plasma generating region, and a vacuum pump.

### SUMMARY OF THE INVENTION

It is therefore a general object of the present invention to provide plasma processing method and processor having a high processing rate and providing uniform surfaces on the processed wafers after the etching processes.

A plasma processor according to the present invention comprises an airtight chamber with a plurality of holes arranged in the base plate of a wafer processing space and through which the activated gas is introduced. The wafer is placed on the base plate while keeping the surface to be etched downward. The wafer is processed by activated etchant gases, blown out from the holes of the base plate. The wafer is floated and rotated by jet streams of etchant gases issuing from the holes, and, at the same time, the wafer is etched. Therefore, the wafer can be etched uniformly with a high processing rate without being affected by ion bombardment, radiation of ultraviolet rays or soft X-rays, and, consequently the reliability and yield of the wafer are improved.

Further details and advantages of the present invention will be apparent from the accompanying drawings and the detailed description of preferred embodiments.

### BRIEF DESCRIPTION OF THE DRAWINGS

Figure 1 shows schematically the principle of a plasma processing method according to the present invention.

Figure 2 is a side and plan view of the top of a base plate for use in carrying out a plasma processing method according to the present invention.

Figure 3 is a side view, partly in cross-section, of another base plate having heaters, for use in carrying out a plasma processing method according to the present invention.

Figure 4 is a side view, partially in cross-section showing the holes provided for the gas in the base plate according to still another embodiment of the plasma processing method according to the present invention.

Figure 5 is a plan view of the base plate in still another embodiment of a plasma processing method according to the present invention.

Figure 6 is a schematic diagram of a plasma processor system according to the present invention.

## DETAILED DESCRIPTION OF PREFERRED EMBODIMENTS

An embodiment of a plasma processor for IC fabrication according to the invention will now be described with reference to the accompanying drawings.

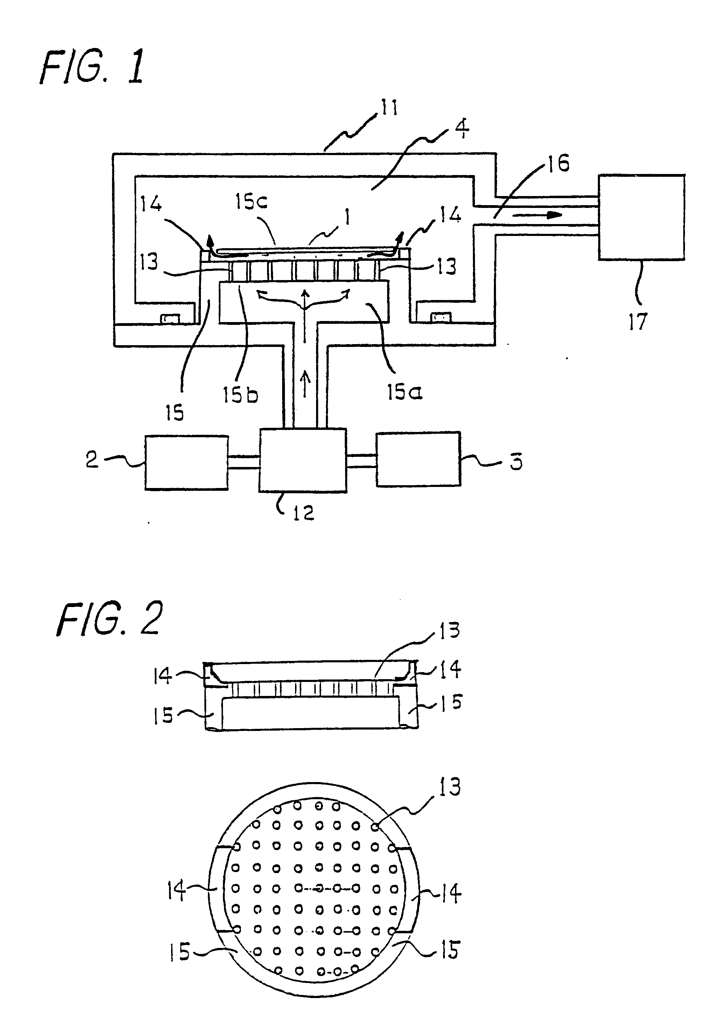

Figure 1 illustrates schematically the principle of a plasma processing method according to the present invention. The plasma processor comprises a plasma generating region 12, which is separated from a reacting region 4 (reactor) located in an airtight reaction chamber 11, and a pumping device 17.

The wafers 1 are placed on the base plate 15 one by one, keeping the surface to be etched downward. Air in the reaction chamber 11 is exhausted by the pumping device 17, and etchant gas is supplied from an etchant gas source 2 into the reacting region 4. When microwave energy generated by a microwave generator 3 is transmitted into the plasma generating region 12, the gas is ionized. Radicals, chemical active species, are generated in the plasma generating region 12, and led into a cavity 15a of the base plate 15. The activated etchant gas spouts out into the reacting region 4, from holes 13 formed through the base plate 15, forming jet streams of etchant gas. Due to these jet streams of etchant gas , the wafer 1 is floated from the top 15c of the base plate 15, and, at the same time, the wafer is etched. Namely, the radicals reaching the underneath surface of the wafer 1, act on the material of the wafer 1 forming volatile compounds. The compounded gases are removed by means of the pumping device 17 through an exhaust tube 16.

The plasma gas, for example oxygen ($O_2$), is generated in the plasma generating region 12, excited by the microwave energy for example at a frequency of 2.45 GHz and introduced into the cavity 15a arranged inside the base plate 15. Oxygen plasma gas is blown out from the gas holes 13 each of which constituting a fine nozzle. The pressure in the reacting region 4 inside the reaction chamber 11 is maintained at about 133 Pa (1 Torr). The pressure inside the cavity 15a is maintained at about 265-400 Pa (2-3 Torr). The gas is blown out due to the difference between these pressures. The radicals of the etchant gas are pressed into the space between the wafer and the top surface of base plate. As a result, the wafer is floated a little due to the pressure of the gas. The gas flows out, as shown by arrow lines in Fig. 1, from a space between the wafer 1 and a guide 14 provided at the periphery of the top portion 15c of the base plate. The floating wafer position is controlled by the gas pressure. When the wafer is floated, the wafer height above the base plate is about 0.1-1.0 mm, the guide 14 extending over this height for protection purposes in order to keep the wafer on the base plate. Due to the flat uniform stream of the etchant gas between the wafer and the base plate, the etching is performed uniformly with a high processing rate. A significative amount of gas used for the processing is saved in comparison with a conventional plasma processor. After plasma processing, the compounded gases are exhausted through the exhaust tube 16 by means of the pumping device 17.

With such a floating wafer processing method, it has then been found that the wafer can be etched uniformly and the processing rate be high, compared to an ordinary dry etching method.

Figure 2 is a side and plan view of the top of the base plate used in connection with the present invention. A plurality of gas holes 13 from 0.5 mm to 2.5 mm in diameter are arranged at about 10 mm steps. The axes of the holes are vertical to the surface of the base plate. The base plate 15 is made of aluminum or titanium.

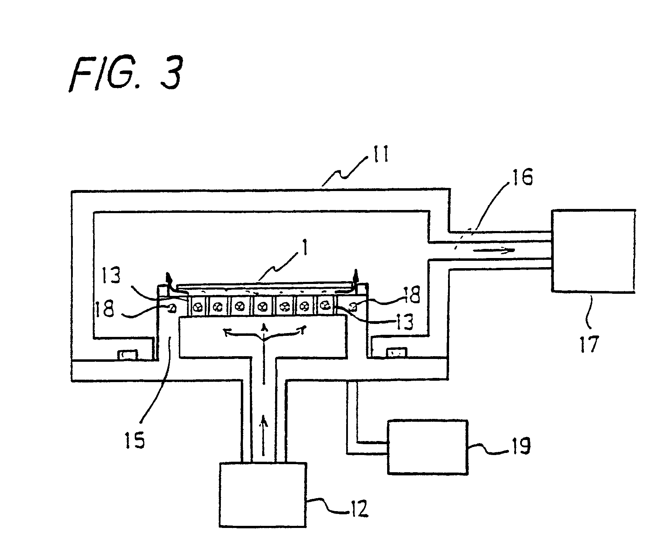

Figure 3 illustrates another plasma processing method according to the present invention. Compared to Figure 1, heaters are provided to heat up the etchant gas. In Figs. 1 and 3, the same reference numerals designate the same or corresponding parts of the processor.

The difference between the base plate of Figure 3 and that of Figure 1 is that the first one is provided with heating elements 18 and a temperature control unit 19. During plasma processing, the etchant gas passing through the holes 13 is heated by the heating elements 18. As a result, the wafer is heated to a proper temperature by heat conduction through the etchant gas. The temperature is controlled by the temperature control unit 19. By heating up the wafer, it is in particular possible to perform the etching process with a high processing rate. It has been found that the operating temperature for the wafer should preferably be of about 150 degrees C to obtain a high processing rate.

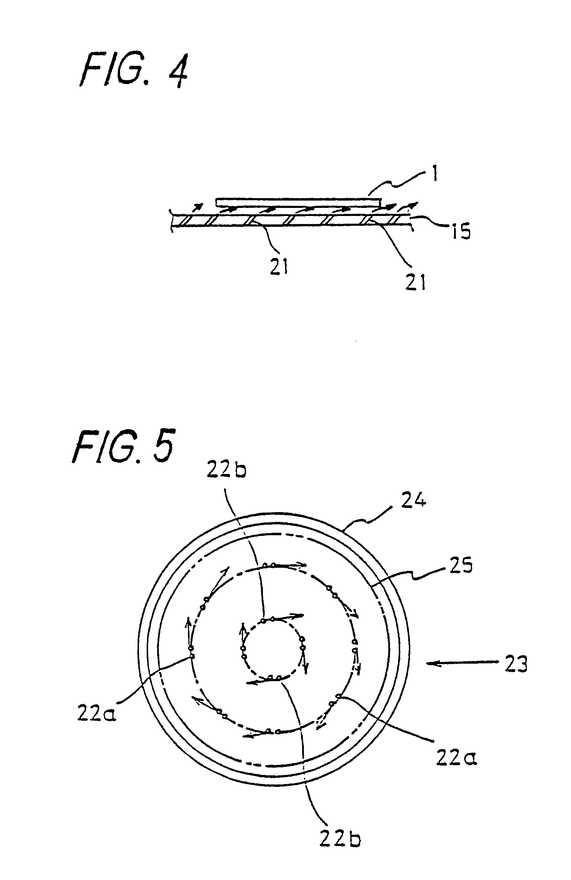

Figure 4 is a side view, partially in cross-section of the gas holes, in still another embodiment of a plasma processing method according to the present invention.

The difference between the construction of the holes 21 of Figure 4 and that of Figure 1 is that the gas holes 21 are arranged in the base plate 15, with their axes inclined to the surface of the base plate. The angle of inclination is comprised between 30 and 60 degrees. Because of the gases flowing as shown by arrows in Figure 4, the wafer is moved forward Then, the wafer 1 is processed by the etchant gas and at a same time, is transferred by the etchant gas in a manner similar to that of an air-bearing which is widely used in wafer handling system.

Therefore, this system can be utilized as a plasma processing system and a wafer transfer system at the same time. It is also possible to switch from plasma processor to air bearing system by switching the gas used.

Figure 5 is a plan view of the base plate in still another embodiment of a plasma processing method according to the present invention. The difference between the base plate 23 of Figure 5 and that of Figure 1 is that the first one has gas holes arranged in order to rotate the wafer. The gas holes are positioned on concentric circles around the center of the base plate 23. Each hole is aslant to the surface of the base plate 23 about 45 degrees for example, in a definite direction along the circle.

In a preferred embodiment (Fig. 5), the holes are arranged at regular intervals on two concentric circles 22a and 22b around the center of the base plate 23. The jets of gas issuing from these holes cause the wafer to float and to rotate at a desired speed determined by the gas streams during plasma processing. By application of this rotational effect, the uniformity of processing is further increased.

Heating elements and a temperature control unit such as described with reference to Fig. 3, are also applicable to the preferred embodiments of Figs. 4 and 5 in order to raise the processing speed. Such an application will be easily understood by the one skilled in the art and, therefore, any further explanation is omitted for the sake of simplicity.

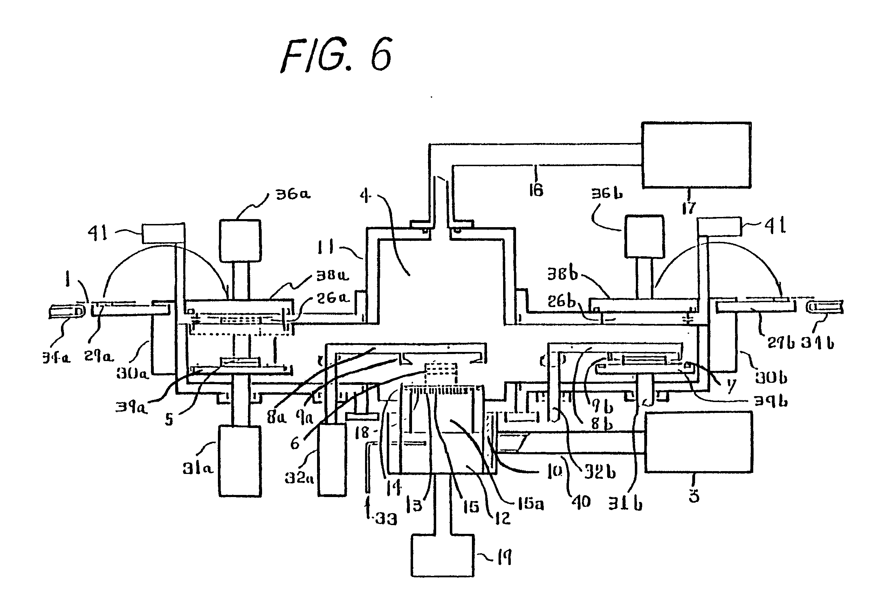

Figure 6 is a schematic diagram of a plasma processor system embodying the present invention. In Figs. 1 and 6, the same or similar reference numerals designate the same or corresponding parts of the processors.

The system illustrated diagrammatically in Figure 6 features a totally automated operation. It does not require any manual handling of wafers or wafer trays. Wafer loading and unloading are accomplished through vacuum load lock spaces 26a and 26b, so that the reaction chamber 11 is maintained in a specified gas pressure and is not exposed to the ambient environment. The load lock space 26a comprises an airtight space which is constituted by the space between an entrance gate valve 38a and a slit gate valve 39a. The slit gate valve 39a is used for communication between the load lock space 26a and the reaction chamber 11. The entire process sequence is microprocessor controlled by means of a control module.

The operation of the system is as follows. A wafer 1 is transported on a polyurethane belt 34a, and moves into position over a vacuum chuck 29a. Before opening the entrance gate valve 38a, the slit gate valve 39a is lifted up by an up and down mechanism 31a and pressed against the upper wall of the reaction chamber 11. The space surrounded by the entrance valve 38a, the slit gate valve 39a and the wall of the reaction chamber 11 forms an airtight load lock space 26a. The gas in the load lock space 26a is evacuated and replaced by air through a pressure preparing system 41, such substitution of gas being done very quickly since the volume of the load lock space 26a is very small (for example, 5 mm high and 15 cm in diameter).

Then, the entrance gate valve 38a is pulled up by an open and close mechanism 36a. The wafer 1 is chucked by the vacuum chuck 29a, turned over by a reverse mechanism 30a, and placed on a stage 5. The entrance gate valve 38a is again closed by the open and close mechanism 36a. Air in the load lock space is replaced this time by gas from the reaction chamber 11. Thereafter, the slit gate valve 39a is pulled down by the up and down mechanism 31a. Thus, the wafer is taken into the reaction chamber 11, without disturbing the condition of the reaction chamber. Therefore, plasma processing can continue while a next wafer is being taken in or taken out. Next, the wafer is chucked by a chuck 9a on an arm 8a which is rotated by a rotation mechanism 32a. The wafer 1 is transferred onto the stage 6 (shown by dotted lines) over the base plate 15. The wafer is lowered downward on the base plate 15, and can now be etched by using the floating wafer processing method of the present invention.

Oxygen ($O_2$) plasma gas, for example, is generated in a plasma generating region 12, excited by microwave energy at a frequency of 2.45 GHz and introduced into a cavity 15a, through an isolator 10. The isolator is a dielectric window formed in a wave-guide 40 for defining a portion of the plasma generating region 12, the dielectric window transmitting microwave power. Oxygen plasma gas is blown out of the gase holes 13 formed in the base plate, which holes are provided with heating elements 18 and a temperature control unit 19. The pressure in the reacting region 4 in the reaction chamber 11 is maintained at about 133 Pa (1 Torr). The pressure of the cavity 15a of the base plate is maintained at about 265-400 Pa (2-3 Torr). The gas is blown out due to the difference between these pressures. The radicals of the etching gas are pressed into the space between the wafer and the top surface of base plate. As a result, the wafer is floated a little by the pressure of the gas. The gas flows out from the space between the wafer 1 and the guide 14. The floating wafer position is controlled by the gas pressure. When the wafer is floated, the wafer height above the base plate is 0.1-1.0mm, the guide 14 being designed to keep the wafer on the base plate 15. Due to the flat uniform stream of the etchant gas between the wafer and the base plate, the wafer is etched uniformly with a high processing rate. A substantial amount of gas used for the processing is saved in comparison with a conventional plasma processor. After plasma processing, the compounded gases are exhausted through the exhaust tube 16 by means of the pumping device 17.

The cycle can be repeated to load or unload. The unloaded wafer is chucked by a chuck 9b on an arm 8b which is rotated by a rotation mechanism 32b, and moved to a stage 7 on a slit gate valve 39b. Next, by using an up and down mechanism 31b, the wafer is moved up into the load lock space 26b. Then, the unloaded wafer is closed inside the load lock space 26b, and the gas in the load lock space 26b is evacuated and replaced by air through the pressure preparing system 41. A load lock valve 38b is opened, by an open and close mechanism 36b, and the wafer on the stage 7 is chucked and turned over by a reverse mechanism 30b. The unloaded wafer is loaded to a return belt 34b and the load lock space 26b is backfilled with gas from the reaction chamber 11. The processed wafer is transported to a receiver cassette (not shown), and the cycle of the processor is completed.

In the plasma processor of Figure 6, the reacting region 4 must be airtight, because a leakage of the etchant gas is dangerous for the operator, and also, otherwise the etchant gas could be contaminated by moisture or dust from the ambient. Therefore, packing or O-rings are provided around the moving shafts or gate valves 38a, 38b and 39a, 39b. And the gas in the reaction chamber 11 is kept to a specific pressure by means of the pumping system 17. For example, the pressure of an etchant gas composed of carbon-tetrafluoride ($CF_4$) or carbon-tetracloride ($CCl_4$) and its pressure of the reacting region 4 in the reacting chamber 11 can be about 40 Pa (0.3 Torr).

The load lock processing provides several advantages : it isolates the reaction chamber from the atmosphere and brings thermal as well as pressure and gas flow stability. Reducing air and moisture content in the chamber improves both etching reproducibility and process uniformity.

Another advantage of the load lock operation is safety. Operators are no longer exposed to the etchant gases used during the plasma processing.

The system can be operated in a continuous processing mode. Namely, while one wafer is in process, another wafer can be taken in or taken out from the reaction chamber. So, the productivity is increased. The throughput in the continuous mode is 60 percent higher as in the standard operating mode (similar to manual systems). Also, etching uniformity is enhanced by using the rotating process system. Etching rate is increased upto about $6\mu m/min$, which is almost twice as far as that of a conventional plasma processor system.

As already mentioned, with the plasma processor of the present invention, the etching is performed at a high speed and the etching uniformity is increased to a great extent compared to a conventional plasma processor.

## Claims

1. A plasma processing method for performing an etching process for a wafer, comprising the steps of :

   placing said wafer at a processing position; and

   blowing a plasma activated etchant gas from the underside of said wafer to float said wafer and at the same time effect the etching at the underside of said wafer.

2. A plasma processing method according to claim 1, characterized in that said etchant gas is heated by heating elements to a specified temperature.

3. A plasma processor comprising :

   an airtight reaction chamber (11) in which a wafer (1) is to be processed, comprising :

   a base plate (15) having a plurality of holes (13) and upon which said wafer is to be positioned with the surface to be processed downward; and

   a means for blowing out a plasma activated etchant gas said holes (13) to float the wafer (1) and etch the underside of said wafer by said etchant gas.

4. A plasma processor according to claim 3, characterized in that said holes (21) are provided aslant to said base plate in a specified direction to transfer said wafer (1) in said specified direction and simultaneously etch said wafer by said etchant gas blown out from said holes.

5. A plasma processor according to claim 3, characterized in that said holes are provided along at least one circle (22a, 22b) around the center of the base plate (23) and aslant to said base plate in a specified direction around the circle to rotate said wafer in said specified direction and simultaneously etch it by said etchant gas blowing out from said holes.

6. A plasma processor according to claim 3, said base plate (15) further comprising :

heating means (18) for heating said etchant gas; and

a temperature controller (19) for controlling said heating means to keep said gas temperature to a specified value.

7. A plasma processor according to claim 3, further comprising :

an etchant gas source (2) for providing said etchant gas;

a plasma generating region (12) for generating a plasma of said etchant gas fed from said gas source to form a plasma activated etchant gas;

a microvave generator (3) for supplying microwave energy to the plasma generating region;

a means for transferring a plasma activated etchant gas to said reaction chamber; and

a pumping device (17) exhausting the gas to keep the reaction chamber at a specified pressure.

8. A plasma processor according to claim 7, further comprising :

a load lock space (26a, 26b) which is an airtight space formed by a space between an entrance gate valve (38a, 38b) and a slit gate valve (39a, 39b), said entrance gate valve and slit gate valve providing communication between outer space and the reaction chamber (11) via said load lock space (26a ,26b)

a pressure preparing system (41) for evacuating said load lock space (26a, 26b) and refilling with the gas which is the same and has the same pressure as that of the space to which said load lock space is connected;

a reverse mechanism (30a, 30b) for picking up said wafer from a conveyor belt (34a) turning it over and placing it on a stage (5) of the slit gate valve (39a) through the entrance gate valve (38a), or picking up said wafer from a stage (7) of the slit gate valve (39b) through the entrance gate valve (38b), turning it over and placing it on a conveyor belt (34b);

an open and close mechanism (36a, 36b) for opening or closing said entrance gate valve (38a, 38b);

an up and down mechanism (31a, 31b) for moving said slit gate valve (39a, 39b) to open or close said load lock space; and

a rotation mechanism (32a , 32b) having a chuck (9a, 9b) on an arm (8a, 8b) to pick up said wafer,for rotating the arm to transfer said wafer from said stage (5,7), of said slit gate valve (39a, 39b) to said base plate (15) of the reaction chamber (11) or vice versa.

**Revendications**

1. Procédé de traitement par plasma permettant d'exécuter un traitement de gravure sur une pastille, comprenant les opérations suivantes :

placer ladite pastille en une position de traitement ; et

insuffler, depuis l'envers de ladite pastille, un gaz de gravure activé en plasma afin de faire flotter ladite pastille et, en même temps, réaliser la gravure sur l'envers de ladite pastille.

2. Procédé de traitement par plasma selon la revendication 1, caractérisé en ce que ledit gaz de gravure est chauffé par des éléments chauffants jusqu'à une température spécifiée.

3. Dispositif de traitement par plasma, comprenant : une chambre de réaction hermétique (11) dans laquelle une pastille (1) doit être traitée, comprenant :

une plaque de base (15) possédant plusieurs trous (13) et sur laquelle ladite pastille doit être placée, la surface à traiter étant tournée vers le bas, et

un moyen permettant d'insuffler un gaz de gravure activé en plasma depuis lesdits trous (13) afin de faire flotter la pastille (1) et de graver l'envers de ladite pastille à l'aide dudit gaz de gravure.

4. Dispositif de traitement par plasma selon la revendication 3, caractérisé en ce que lesdits trous (21) sont réalisés de façon à être inclinés par rapport à ladite plaque de base suivant une direction spécifiée, afin de transporter ladite pastille (1) dans ladite direction spécifiée et, simultanément, graver ladite pastille à l'aide du gaz de gravure insufflé par lesdits trous.

5. Dispositif de traitement par plasma selon la revendication 3, caractérisé en ce que lesdits trous sont ménagés suivant au moins un cercle (22a, 22b) entourant le centre de la plaque de base (23) et sont inclinés par rapport à ladite plaque de base suivant une direction spécifiée le long du cercle de manière à faire tourner ladite pastille dans ladite direction spécifiée et, en même temps, la graver à l'aide du gaz de gravure insufflé par lesdits trous.

6. Dispositif de traitement par plasma selon la revendication 3, ladite plaque de base (15) comprenant en outre :

des moyens de chauffage (18) servant à chauffer ledit gaz de gravure ; et

un dispositif (19) de commande de température servant à commander lesdits moyens de chauffage afin de maintenir la température dudit gaz à une valeur spécifiée.

7. Dispositif de traitement par plasma selon la revendication 3, comprenant en outre :

une source de gaz de gravure (2) servant à produire ledit gaz de gravure ;

une région productrice de plasma (12) servant à produire un plasma dudit gaz de gravure fourni par ladite source de gaz afin de former un gaz de gravure activé en plasma ;

un générateur d'hyperfréquences (3) servant à fournir une énergie hyperfréquence à la région productrice de plasma ;

un moyen servant à transporter jusqu'à ladite chambre de réaction un gaz de gravure activé en plasma ; et

un dispositif de pompage (17) servant à faire sortir le gaz de façon à maintenir la chambre de réaction à une pression spécifiée.

8. Dispositif de traitement par plasma selon la revendication 7, comprenant en outre :

un sas de chargement (26a, 26b) qui est un espace hermétique formé de l'espace compris entre une vanne d'entrée (38a, 38b) et une vanne à fente (39a, 39b), lesdites vanne d'entrée et vanne à fente assurant la communication entre l'espace externe et la chambre de réaction (11) via ledit sas de chargement (26a, 26b) ;

un système de préparation de pression (41) servant à faire le vide dans ledit sas de chargement (26a, 26b) et à remplir celui-ci à l'aide d'un gaz qui est identique et a la même pression que celui contenu dans l'espace auquel le sas de chargement est raccordé ;

un mécanisme de retournement (30a, 30b) servant à prélever ladite pastille sur une bande transporteuse (34a), à la retourner et à la placer sur une platine (5) de la vanne à fente (39a) via la vanne d'entrée (38a), ou bien à prélever ladite pastille sur une platine (7) de la vanne à fente (39b) via la vanne d'entrée (38b), à la retourner et à la placer sur une bande transporteuse (34b) ;

un mécanisme d'ouverture et de fermeture (36a, 36b) servant à ouvrir ou fermer ladite vanne d'entrée (38a, 38b) ;

un mécanisme de soulèvement et d'abaissement (31a, 31b) servant à déplacer ladite vanne à fente (39a, 39b) afin d'ouvrir ou de fermer ledit sas de chargement ; et

un mécanisme rotatif (32a, 32b) possédant un mandrin (9a, 9b) disposé sur un bras (8a, 8b) pour prélever ladite pastille, afin de faire tourner le bras pour transporter ladite pastille de ladite platine (5, 7) de la vanne à fente (39a, 39b) à ladite plaque de base (15) de la chambre de réaction (11) ou inversement.

**Patentansprüche**

1. Plasmabearbeitungsverfahren zum Durchführen eines Ätzprozesses für ein Wafer mit den folgenden Schritten:

Plazieren des Wafers in eine Bearbeitungsposition; und

Blasen von plasmaaktiviertem Ätzgas von der Unterseite des Wafers, um das Wafer schwimmen zu machen und gleichzeitig das Ätzen an der Unterseite des Wafers zu bewirken.

2. Plasmabearbeitungsverfahren nach Anspruch 1, dadurch gekennzeichnet, daß das genannten Ätzgas durch Heitzelemente auf eine spezifische Temperatur aufgeheizt wird.

3. Plasmaprozessor mit:

einer luftdichten Kammer (11), in der ein Wafer (1) bearbeitet werden soll, mit:

einer Basisplatte (15), die eine Vielzahl von Löchern (13) hat und auf der das genannte Wafer mit der zu bearbeitenden Oberfläche nach unten zu positionieren ist; und

einer Einrichtung, um plasmaaktiviertes Ätzgas von den genannten Löchern (13) auszublasen, um das Wafer (1) schwimmend zu machen und die Unterseite des genannten Wafers durch das genannte Ätzgas zu ätzen.

4. Plasmaprozessor nach Anspruch 3, dadurch gekennzeichnet, daß die genannten Löcher (21) zu der genannten Basisplatte in einer spezifischen Richtung geneigt vorgesehen sind, um das genannte Wafer (1) in die genannte spezifische Richtung zu transferieren und gleichzeitig das genannte Wafer durch das Ätzgas, das von den genannten Löchern ausgeblasen wird, zu ätzen.

5. Plasmaprozessor nach Anspruch 3, dadurch gekennzeichnet, daß die genannten Löcher längs wenigstens einem Kreis (22a, 22b) um das Zentrum der Basisplatte (23) und in einer spezifischen Richtung zu der genannten Basisplatte geneigt längs den Kreis angeordnet sind, um das genannte Wafer in der genannten spezifischen Richtung zu rotieren und es gleichzeitig durch das genannte Ätzgas, das von den genannten Löchern ausgeblasen wird, zu ätzen.

6.  Plasmaprozessor nach Anspruch 3, bei dem die genannte Basisplatte (15) ferner umfaßt:

Heizeinrichtungen (18) zum Heizen des genannten Ätzgases; und

einen Temperatursteuerer (19) zum Steuern der genannten Heizeinrichtungen, um die genannte Gastemperatur auf einem spezifischen Wert zu halten.

7.  Plasmaprozessor nach Anspruch 3, ferner mit:

einer Ätzgasquelle (2), um das genannte Ätzgas zu liefern;

einen Plasmagenerationsbereich (12), zum Generieren eines Plasmas des genannten Ätzgases, welches von der genannten Gasquelle gespeist wird, um ein plasmaaktiviertes Ätzgas zu bilden;

einen Mikrowellengenerator (3), um Mikrowellenenergie zu dem Plasmagenerationsbereich zu liefern;

einer Einrichtung zum Übertragen eines plasmaaktivierten Ätzgases zu der genannten Reaktionskammer; und

einer Pumpvorrichtung (17), die das Gas absaugt, um die Reaktionskammer auf einem spezifischen Druck zu halten.

8.  Plasmaprozessor nach Anspruch 7, ferner mit:

einem Lastverriegelungsraum (26a, 26b), der ein luftdichter Raum ist, der durch den Raum zwischen einem Eingangsabsperrventil (38a, 38b) und einem Schlitzabsperrventil (39a, 39b) gebildet ist, wobei das Eingangsabsperrventil und das Schlitzabsperrventil eine Kommunikation zwischen dem äußeren Raum und der Reaktionskammer (11) über den genannten Lastverriegelungsraum (26a, 26b) vorsehen,

einem Druckpräparierungssystem (41), um den genannten Lastverriegelungsraum (26a, 26b) zu evakuieren und ihn erneut mit dem Gas zu füllen, welches dasselbe ist und denselben Druck hat, wie das des Raumes, mit dem der genannte Lastverriegelungsraum verbunden ist;

einem Umkehrmechanismus (30a, 30b), um das genannte Wafer von dem Förderband (34a) abzuheben, es umzudrehen und auf eine Bühne (5) des Schlitzabsperrventils (39a) zu plazieren, durch das Eingangsabsperrventil (38a), oder das Wafer von einer Bühne (7) des Schlitzabsperrventils (39b) durch das Eingangsabsperrventil (38b) abzuheben, es umzudrehen und auf ein Förderband (34b) zu plazieren;

einem öffnungs- und Schließmechanismus (36a, 36b), zum Öffnen oder Schließen des genannten Eingangsabsperrventils (38a, 38b);

einem Auf- und Abmechanismus (31a, 31b), um das genannte Schlitzabsperrventil (39a, 39b) zu bewegen, um den genannten Lastverriegelungsraum zu öffnen oder zu schließen; und

einem Rotationsmechanismus (32a, 32b), der ein Futter (9a, 9b) an einem Arm (8a, 8b) hat, um das genannte Wafer aufzunehmen, um den Arm zu rotieren, um das Wafer von der genannten Bühne (5, 7) des genannten Schlitzabsperrventils (39a, 39b) zu der Basisplatte (15) der Reaktionskammer (11) zu transferieren oder umgekehrt.

# FIG. 1

# FIG. 2

# FIG. 3

## FIG. 4

## FIG. 5

## FIG. 6